# EUROPEAN PATENT APPLICATION

(11) **EP 4 379 793 A1**
(43) Date of publication of application: **05.06.2024**
(21) Application number: 23212313.3
(22) Date of filing: 27.11.2023
(51) Int. Cl.: H01L 23/367, H01L 23/373

(54) **SEMICONDUCTOR PACKAGING SUBSTRATE, SEMICONDUCTOR PACKAGES, AND METHOD FOR MANUFACTURING THE SEMICONDUCTOR PACKAGING SUBSTRATE**

(30) Priority: 02.12.2022 US 202263429563 P
(71) Applicant: Absolics Inc., Covington, GA 30014 (US)
(72) Inventor: KIM, Sungjin, Covington, Georgia, 30014 (US)
(74) Representative: BCKIP Part mbB

(57) **Abstract**

Embodiments relate to a semiconductor packaging substrate, a semiconductor package, and a method for manufacturing the semiconductor packaging substrate, wherein a substrate comprises one surface, another surface facing the one surface, a recessed surface that is recessed in the one surface, and a side wall connecting the one surface and the recessed surface; and plurality of first vias that penetrate the recessed surface and the other surface; wherein the plurality of first vias include a thermally conductive material. Embodiments have an excellent heat dissipation effect and can prevent warpage on the surface of the substrate due to thermal expansion.

## Description

### BACKGROUND

### 1. Field of the Invention

The present disclosure relates to a semiconductor, specifically, it relates to a substrate for semiconductor packaging, a semiconductor package, and a method for manufacturing the substrate for semiconductor packaging.

### 2. Discussion of Related Art

In the manufacturing of electronic components, the implementation of a circuit on a semiconductor wafer is referred to as a Front-End Process (FE), and the assembly of a wafer such that it can be actually used in a product is referred to as a Back-End Process (BE). Back-End process includes a packaging process.

Four key technologies of the semiconductor industry that enable the rapid development of electronic products in recent years include semiconductor technology, semiconductor packaging technology, manufacturing process technology, and software technology. Semiconductor technology has been developed in various forms such as line width of a nanometer unit, which is smaller than a micrometer unit, 10 million or more cells, high-speed operation, much heat dissipation, and the like, but packaging technology is not being supported completely.

In particular, when a semiconductor package including a heating element does not dissipate heat properly, since each package components has its distinguishable thermal expansion coefficient, warpage phenomenon may occur. This increases the defect rate of semiconductors. Conventional semiconductor packages attempted to dissipate heat by additionally providing an interposer layer or heat dissipation layer, but this makes a problem in that a thickness of a semiconductor package increases.

### SUMMARY OF THE INVENTION

An embodiment is directed to providing a semiconductor packaging substrate, a semiconductor package, and a manufacturing method of a semiconductor packaging substrate with thermal stability without substantially increasing a thickness of the semiconductor package.

To achieve the above objectives, a semiconductor packaging substrate according to one embodiment includes a substrate having one surface, other surface facing the one surface, a recessed surface that the one surface recessed, and a side wall connecting the one surface and the recessed surface, and
plurality of first vias that penetrating the recessed surface and the other surface,
wherein the plurality of first vias includes a thermal conductive material.

The substrate may include a glass substrate.

The substrate may include an insulator substrate.

The one surface and the other surface may have surface roughness (Ra) of 10 Å or less, respectively.

The substrate may include plurality of second vias that penetrating the one surface and the other surface.

An area of the recessed surface may be 10% or more of the area of the one surface.

To achieve the above objectives, a semiconductor package according to one embodiment includes a substrate having one surface, other surface facing the one surface, a recessed surface that the one surface recessed, and a side wall connecting the one surface and the recessed surface;
plurality of first vias that penetrating the recessed surface and the other surface; and
an element unit disposed on the recessed surface,
wherein the plurality of first vias comprise a thermal conductive material.

The substrate may include a glass substrate.

The substrate may include an insulator substrate.

The one surface and the other surface may have surface roughness (Ra) of 10 Å or less, respectively.

The substrate may include plurality of second vias that penetrating the one surface and the other surface.

The element unit may include an active element.

The semiconductor package may include filling materials covering the element unit.

The filling materials may have a lower coefficient of thermal expansion than that of the substrate.

An angle between the side wall and the recessed surface may be an obtuse angle.

To achieve the above objectives, a method for manufacturing the semiconductor packaging substrate according to one embodiment includes a preparation operation of forming a defect at a predetermined location on a one surface of a substrate, other surface facing the one surface, or both;
a via forming operation of applying an etchant to the substrate to form a plurality of vias and recessed surface; and
a filling operation of filling the plurality of vias with a thermal conductive material.

### BRIEF DESCRIPTION OF THE DRAWINGS

The above and other objects, features and advantages of the present disclosure will become more apparent to those of ordinary skill in the art by describing in detail exemplary embodiments thereof with reference to the accompanying drawings, in which:
FIG. 1 is a perspective view of a semiconductor package according to one embodiment.
FIG. 2 is a cross-section of a semiconductor packaging substrate which a part of A-A' cross section of the FIG. 1.
FIG. 3 is a cross-section of a semiconductor packaging substrate according to another embodiment which a part of A-A' cross section of the FIG. 1.
FIG. 4 is a cross-section of a semiconductor package which a part of A-A' cross section of the FIG. 1.
FIG. 5 is a cross-section of a semiconductor package according to another embodiment which a part of A-A' cross section of the FIG. 1.
FIG. 6 is a cross-section of a semiconductor package according to another embodiment which a part of A-A' cross section of the FIG. 1.
FIG. 7 is a cross-section of a semiconductor package according to another embodiment which a part of A-A' cross section of the FIG. 1.
FIG. 8 is a cross-section of a semiconductor package according to another embodiment which a part of A-A' cross section of the FIG. 1.

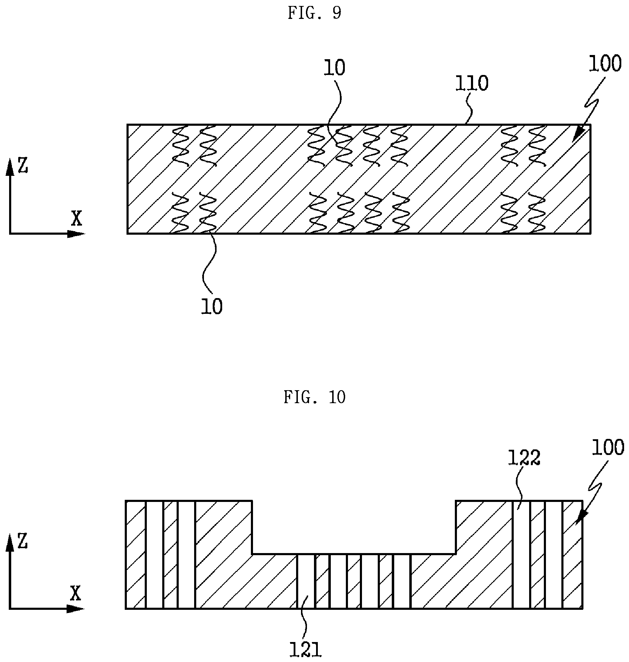

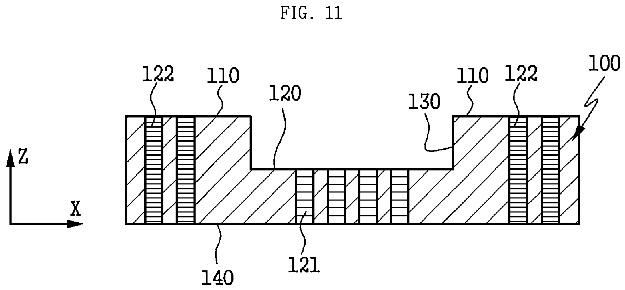

FIGS. 9 to 11 are conceptual views for descripting method of semiconductor packaging according to embodiment.

### DETAILED DESCRIPTION OF EXEMPLARY EMBODIMENTS

Hereinafter, embodiments will be described in detail with reference to the accompanying drawings which may allow those skilled in the art to easily practice the present disclosure. However, the embodiment may be implemented in various forms and is not limited to the embodiments described herein. The same reference numerals are used for similar components throughout the specification.

Throughout the present specification, the term "combination thereof" included in expression of the Markush form refers to a mixture or combination of one or more selected from the group consisting of components disclosed in the expression of the Markush form, and refers to including one or more selected from the group consisting of the components.

Throughout the present specification, terms such as "first," "second," "A" or "B" are used to distinguish the same terms. Further, a singular form includes a plural form unless otherwise defined in the context.

In the present specification, "~based" may refer to including a compound corresponding to "-" or a derivative of the "~" in the compound.

In the present specification, "B is located on A" means that B is located directly on A or B is located on A while another layer is located therebetween, and is not understood as being limited to a case in which B is located on the surface of A.

In the present specification, "B is connected on A" means that B is directly connected to A or B is connected to A through another component therebetween, and is not understood as being limited to a case in which B is directly connected to A unless otherwise specifically mentioned.

In the present specification, a singular form is interpreted as including a singular form or plural form unless otherwise specifically described.

In the present specification, a substrate on which elements are not mounted is referred to as a semiconductor packaging substrate, and a substrate on which elements are mounted is a referred to as a semiconductor package, but a semiconductor package may further mound additional elements.

The inventors of the embodiment recognized that not only the device itself but also the packaging is an important factor in improving performance in the process of developing a semiconductor device capable of exhibiting high performance with a more integrated and thinner thickness. Conventionally, two or more layers of packaging substrates such as interposers and organic substrates were applied on the motherboard. However, the inventors try to make a packaging substrate as a single layer. And, in this procedure, they confirmed that the effect of preventing a warpage phenomenon on the substrate surface due to thermal expansion by helping the heat dissipation of the semiconductor device through forming a thermal via at the recess of a packaging substrate, so they present these embodiments.

In the present specification, shapes, relative sizes, angles, and the like of components in the drawings are illustrative and may be exaggerated for the purpose of description, and the scope is not understood as being limited to the drawings.

In the present specification, unless otherwise described, a fine line refers to a line having a width of 5 µm or less, for example, refers to a line having a width of 1 to 4 µm or less.

Hereinafter, embodiments will be described with reference to the accompanying drawings.

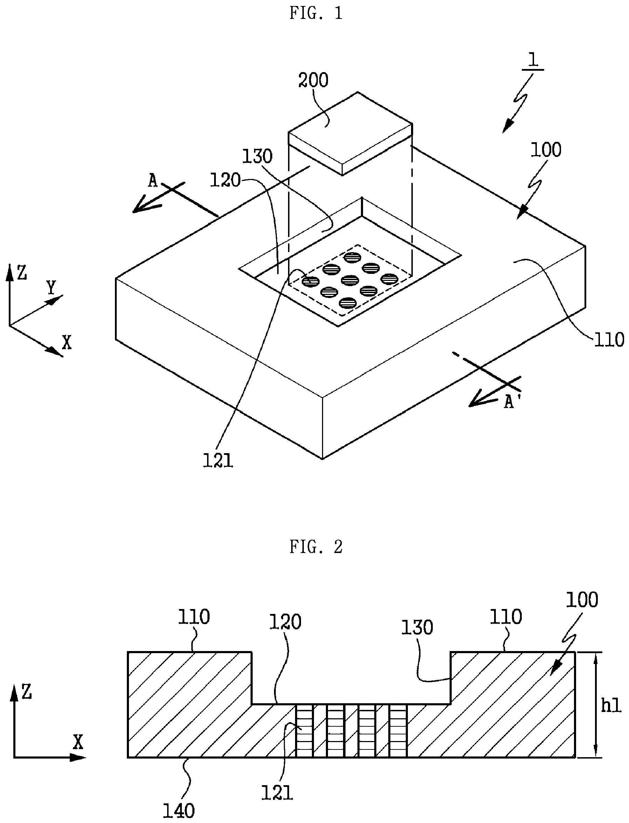

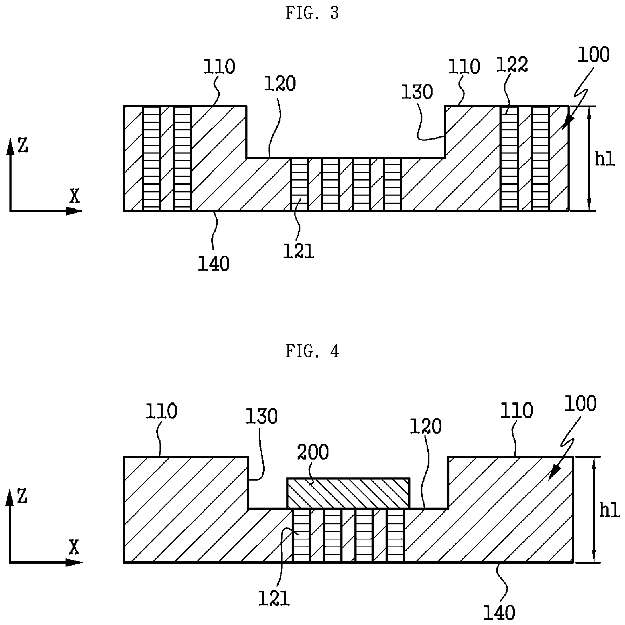

FIG. 1 is a conceptual view of a semiconductor packaging substrate. FIG. 2 is a schematic cross-sectional view taken along A-A' of FIG. 1. FIGS. 3 to 4 are schematic cross-sectional views of a semiconductor package according to another embodiment taken along A-A' of Fig. 1.

Referring to FIGS. 1 to 2, a semiconductor packaging substrate according to some embodiments comprises a substrate 100 and a first via 121.

The substrate 100 may comprise one surface 110, other surface 140 facing the one surface, a recessed surface 120 that the one surface is recessed, and a sidewall 130 connecting the one surface and the recessed surface.

The substrate 100 may be, for example, a ceramic substrate or a glass substrate.

Examples of the ceramic substrate may comprise a silicon-based ceramic substrate, a glass-based ceramic substrate, and the like. The silicon-based ceramic substrate may be a substrate partially or entirely comprising a silicon substrate, a silicon carbide substrate, or the like. The glass-based ceramic substrate may be a substrate partially or entirely comprising a quartz substrate, a sapphire substrate, or the like.

The glass substrate may be, for example, an alkali borosilicate glass plate, an alkali-free alkaline earth borosilicate glass plate, or the like, and any glass plate applied as a part of an electronic product may be applied.

The glass substrate may be manufactured in the form of a large panel. Therefore, when a glass substrate is applied to the substrate 100, mass production is relatively easy and processability can be improved. In this case, it is relatively easy to enlarge the area of the recessed surface 120 described later.

Glass plate as a glass substrate, is itself an insulator. Therefore, when a glass substrate is applied to the substrate 100, it is not essential to coat an insulating layer on the inner surfaces of the plurality of first vias 121 and the plurality of second vias 122 described later. Through this, it is possible to further simplify the manufacturing process of the semiconductor package.

The substrate 100 may have a thickness h1 of 30 µm or more, 50 µm or more, 100 µm or more, 250 µm or more, 400 µm or more, or 500 µm or more. The substrate may have a thickness h1 of 3,000 µm or less, 1,000 µm or less, 300 µm or less, 200 µm or less, or 150 µm or less. When the substrate of thickness is applied in this range, it can have excellent utilization as a semiconductor packaging substrate.

When a glass substrate is applied to the substrate 100, one surface 110 and the other surface 140 of the substrate may have even surface characteristics rather than rough surface.

Specifically, the surface roughness Ra of the one surface and the other surface may be 10 Å or less, 5 Å or less, or 2 Å or less. The surface roughness Ra may be 1 Å or more. In this case, it may be relatively easy to form a fine pattern on the substrate 100.

The surface roughness Ra can be measured by a conventional substrate surface roughness measuring method, and exemplarily it may be measured by a method based on SEMI D7-97 "Method of measuring surface roughness of an FPD glass substrate."

When a glass substrate is applied as the substrate 100, the recessed surface may have a significantly low surface roughness.

In particular, the surface roughness Ra of the recessed surface 120 may be 10 Å or less, 5 Å or less, or 2 Å or less. The surface roughness Ra may be 1 Å or more.

Also, in the recessed surface 120, a difference between an area of the recessed surface viewed from the opening of the recessed surface 120 and an area measured along the actual recessed surface may be insignificant. Specifically, the recessed surface 120 was generally rougher than the surface before being recessed, and thus may have a relatively larger surface area.

In embodiments, when the entire area of the recessed surface viewed from the opening is 100%, the difference from the area measured along the recessed surface may be 0.1 to 10%, 0.1 to 5%, or 0.1 to 3%. Since the area measured along the recessed surface tends to appear wider, the area measured along the recessed surface may be an area between 100.1% to 110%, between 100.1% to 105%, or between 100.1% to 103% of an area of the recessed surface viewed from above the opening.

This is a characteristic that is difficult to obtain in existing pre-flag-based substrates, and a surface roughness of the recessed surface can be prepared to be more lower by applying a process including etching to the recessed surface.

When a glass substrate is applied to the substrate 100, it is easy to enlarge an area of the recessed surface 120. The recessed surface 120 may be 10% or more, 20% or more, 30% or more, or 40% or more of the total area of the one surface before being recessed. The recessed surface 120 may be 70% or less, 60% or less, or 50% or less of the total area of the one surface before being recessed. When the recessed surface 120 having such an area range is applied to the substrate 100, a plurality of elements may be disposed so as to be buried in the substrate, and thus a more integrated semiconductor package may be obtained.

The plurality of first vias 121 comprise thermal via

The plurality of first vias 121 may comprise conductive vias electrically connecting an element unit 200 and a printed circuit board 500.

The plurality of first vias 121 may comprise thermal vias and conductive vias.

The thermal via may be connected to a separate heat transfer structure.

The thermal via may be grounded.

The thermal via may not transmit an electrical signal to the element unit.

The thermal via may comprise a thermally conductive material. The thermally conductive material may be applied as long as it is a thermally conductive material applicable to the packaging substrate, for example, the thermal conductive material may be gold (Au), silver (Ag), copper (Cu), nickel (Ni), aluminum (Al), or combinations thereof.

The thermal conductive material may have a thermal conductivity of 200 W/m.K or higher, 300 W/m.K or higher, or 400 W/m.K or higher. The upper limit of the thermal conductivity of the thermal conductive material is not particularly limited, but may be exemplarily 5,000 W/m.K or less.

At least a portion of the plurality of first vias 121 may overlap a portion of the element unit 200 described later in the third direction Z. When the element unit 200 comprises a heating element, the plurality of first vias 121 may transfer generated heat in the third direction (Z). Accordingly, the plurality of first vias 121 may reduce thermal resistance of the substrate. From that, the plurality of first vias 121 may prevent or mitigate a warpage phenomenon that may occur on the surface of the substrate, thereby improving performance of the semiconductor package.

Referring to FIG. 3, a semiconductor packaging substrate according to some embodiments may comprise a plurality of second vias 122 penetrating one surface 110 and other surface 140 of the substrate 100.

The plurality of second vias 122 may be, for example, conductive vias. When the plurality of second vias 122 are conductive vias, the plurality of second vias 122 may comprise a conductive material. The plurality of second vias 122 can allow the upper layer 400 disposed on one surface 110 of the substrate 100 to be described later and the printed circuit board 500 disposed on the other surface 140 to be described later to send and receive electrical signals.

Other descriptions of a substrate for semiconductor packaging are omitted because they overlap with the above description.

Referring to FIG. 4, a semiconductor package according to some embodiments may further comprise an element unit 200 on the above-described semiconductor packaging substrate.

An upper surface of the element unit 200 may be formed lower than an upper surface of the one surface 110. In this case, a recess may relatively easily compensate for a level difference between one surface and the recessed surface by further comprising the filling material 300 covering the device part.

Alternatively, an upper surface of the element unit 200 may be formed on substantially the same plane as the upper surface of the one surface 110 (not shown). In this case, a recess may fill the empty space using a relatively small amount of the filling material 300. Specifically, an element unit 200 may be disposed to be buried in a substrate 100. That is, a semiconductor package 1 may be an embedded package in which an element unit 200 is buried in a substrate 100.

FIG. 1, FIGS. 4 to 8, etc., it is shown that one element is disposed in the element unit 200, but the embodiment is not limited thereto.

That is, two or more elements may be stacked in the third direction (Z). In some other embodiments, two or more semiconductor chips may be disposed apart from each other in the first direction (X) or the second direction (Y).

The element unit 200 may comprise an active element. For example, any one from an application processor (AP), a power management integrated circuit (PMIC), a central processing unit (CPU), a controller, and an application specific integrated circuit (ASIC) may be comprised.

The element unit 200 may comprise a passive element. For example, it may comprise any one of a capacitor, a resistor, and an inductor.

The element unit 200 may comprise both active elements and passive elements.

The element unit 200 may be electrically connected to the substrate 100. Although not shown in the drawings, for example, an element unit 200 and a substrate 100 may be connected through a wire bonding method. In addition, an element unit 200 and a substrate 100 may be connected through a method using ball-shaped bumps (Flip Chip, FC). However, the method of connection is not limited thereto.

Other descriptions of the semiconductor packaging substrate are omitted because they overlap with the above description.

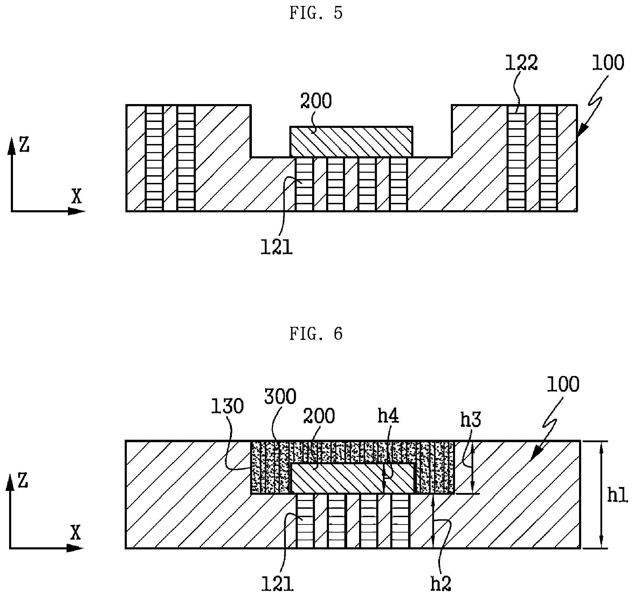

Referring to FIG. 5, a semiconductor package according to some embodiments may comprise a plurality of second vias 122 penetrating one surface 110 and the other surface 140 of a substrate 100.

The plurality of second vias 122 may be, for example, conductive vias. When the plurality of second vias 122 are conductive vias, the plurality of second vias 122 may comprise a conductive material. The plurality of second vias 122 may be electrically connected to the upper layer 400.

Referring to FIG. 6, a semiconductor package according to some embodiments may further comprise a filling material 300. Specifically, the filling material 300 may be disposed to surround the element unit 200. When the height of the element unit is h4 and the depth of the recessed surface is h3, the filler may be disposed to surround the difference. The filler can flatly fill the recessed surface. Although not shown in the drawings, a rewiring layer may be disposed on the filler.

In FIG. 6, the sidewall 130 of the substrate 100 is illustrated as being spaced apart from the element unit 200, but it is not limited thereto. In some other embodiments, at least a portion of the sidewall 130 of the substrate 100 may directly contact the element unit 200. In this case, the filling material 300 may be disposed to cover the upper surface of the element unit 200 or to fill a gap between the side wall of the substrate and the element unit.

The filling material 300 may be a thermosetting material, a thermoplastic material, a UV curing material, or the like. The filling material 300 may be a silicone-based material, an epoxy-based material, an acryl-based material, or the like. The filling material 300 may be a polymer material or an organic-inorganic composite material in which inorganic particles are dispersed in the polymer material. The filling material 300 may be ABF (Ajinomoto Build-up Film, ABF), EMC (Epoxy Molding Compound), LCP (liquid crystal polymer, LCP) and the like. However, the filling material is not limited to the above.

Other descriptions of semiconductor packaging and the semiconductor package are omitted because they overlap with the above description.

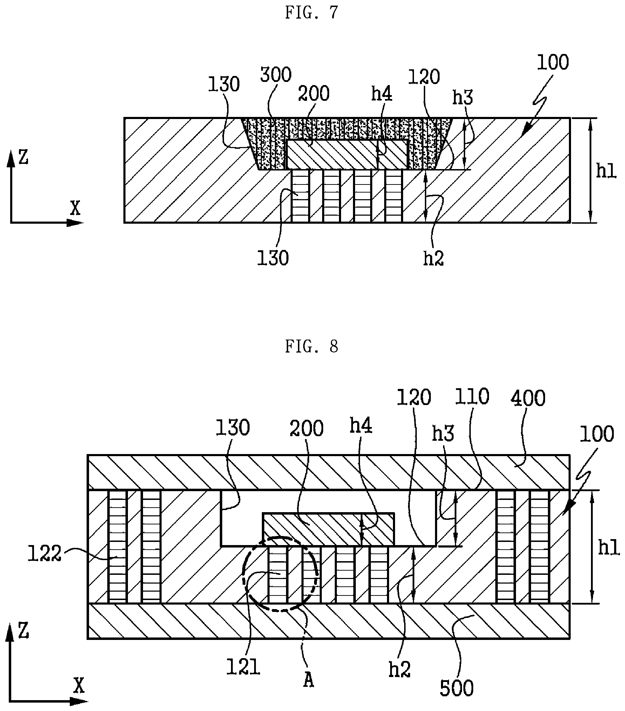

Referring to FIG. 7, in a semiconductor package according to some embodiments, an angle between a sidewall 130 and a recessed surface 120 may be an obtuse angle. In particular, the obtuse angle may be 91 degree or more, 93 degree or more, or 95 degree or more. And the obtuse angle may be 130 degree or less, 120 degree or less, or 110 degree or less. In this case, the amount of filling material 300 required for the process can be reduced. Other descriptions of the semiconductor packaging substrate and the semiconductor package are omitted because they overlap with the above description.

Referring to FIG. 8, a semiconductor device according to some embodiments may further comprise an upper layer 400 and a printed circuit board 500 in the above-described semiconductor package.

In the upper layer 400, a layer capable of transmitting and receiving electrical signals may be disposed. For example, it may comprise a redistribution layer (RDL), a layer in which one or more semiconductor packages are mounted. However, it is not limited thereto as long as it is a structure that can be mounted on a substrate for semiconductor packaging. For example, the upper layer may comprise a silkscreen layer that does not send and receive electrical signals.

The printed circuit board 500 may be electrically connected to the upper layer 400 through the second via 122.

Hereinafter, a method of manufacturing a semiconductor packaging substrate according to another exemplary embodiment will be described.

A method for manufacturing the semiconductor packaging substrate of an embodiment comprises a preparation operation of forming a defect at a predetermined location on a one surface of a substrate, other surface facing the one surface, or both; a via forming operation of applying an etchant to the substrate to form a plurality of vias and recessed surface; and a filling operation of filling the plurality of vias with a thermal conductive material.

In the via forming operation, i) defects for forming vias penetrating the substrate, ii) defects for forming a recessed surface, iii) defects for forming vias penetrating the recessed surface and other surface, and combination thereof may be prepared on the one surface and the other surface of the substrate. The i), and the ii) may be prepared after preparing of the iii), separately. Also, after preparing of the ii), the i) and the iii) may be prepared together. For etching, masking a surface not to be etched is performed and then an etching solution may be applied. It brings for a predetermined portion (non-masked portion) to be selectively etched, and the etching rate of the defect-formed portion is faster than that of the non-defective portion. By allowing it to be etched, it is possible to form recessed surfaces and vias.

Among the plurality of vias, vias overlapping a recessed surface in the third direction (Z) may form a first vias.

Among the plurality of vias, vias that do not overlap with the recessed surfaces in the third direction (Z) may form second vias.

The filling operation may comprise a thermal via filling procedure of filling at least a portion of the via with a thermal conductive material, and a conductive via filling procedure of filling at least a portion of the via with a conductive material. The thermal via filling procedure and the conductive via filling procedure may be performed simultaneously. In this case, a more efficient process can be performed.

A method for manufacturing the semiconductor packaging substrate will be described in more detail.
1) Preparation step (glass defect formation process): A substrate having one flat surface and the other surface is prepared, and a defect is formed at a predetermined position of the substrate to form a via. A glass substrate may be applied to the substrate, and for example, an alkali borosilicate glass plate, an alkali-free alkaline earth borosilicate glass plate, or the like may be applied, and any glass plate applied as a part of an electronic product may be applied. As commercially available products, products manufactured by manufacturers such as Corning, Schott, and AGC may be applied. A method such as mechanical etching or laser irradiation may be applied to the formation of the defect (groove).
2) Via formation step: A plurality of vias and/or recesses are formed on the defective substrate through a physical or chemical etching process. When a glass substrate is applied to the substrate, the defective substrate itself may be etched.

In the etching process, after masking a portion of the target surface before the etching process, an etching solution may be applied to selectively etch a predetermined portion (non-masked portion).

The etching may cause the defective portion to be etched faster than the non-defective portion, thereby forming a recessed surface and/or a via.

In this case, the process can be simplified by eliminating the hassle of applying and removing the masking film. In this case, the thickness of the substrate having vias may be slightly thinner than the thickness of the original substrate.

3) Filling step: Inner surfaces of the plurality of vias may be coated with an insulating layer. However, when a glass substrate is applied to the substrate, the coating of the insulating layer may be omitted. In this case, the surface of the substrate and the inner surfaces of the plurality of vias may be sputtered with a glass-metal adhesive having excellent adhesion to glass (not shown). Meanwhile, a conductive material or a thermal conductive material may be sputtered on the glass-metal adhesive to form a seed layer (not shown). Subsequently, the via is filled with a conductive material or a thermal conductive material and a current is applied to the seed layer (not shown). After sufficient time has passed, the filled via with conductive material or thermal conductive material is formed by chemical-mechanical polishing (CMP) of the one surface or the other surface of the substrate (not shown).

Meanwhile, a first via at a predetermined position among the vias may be filled with a thermal conductive material through a first via filling process. The thermal conductive material may be exemplary gold (Au), silver (Ag), copper (Cu), nickel (Ni), aluminum (Al), or a combination thereof. However, it is not limited thereto as long as it is a thermal conductive material applicable to the packaging substrate. A second via at a predetermined position may be filled with a conductive material through a second via filling process. Also, the thermal conductive material and the conductive material may comprise the same material. For example, copper (Cu) may be comprised as a filling material for the first via and the second via because of its high thermal and electrical conductivity. In this case, the first via filling process and the second via filling process may be performed simultaneously.

The semiconductor packaging substrate, semiconductor packages of embodiment, and a semiconductor packaging substrate produced by method of manufacturing of embodiment have an excellent heat dissipation effect.

And, the semiconductor packaging substrate, semiconductor packages of embodiment, and a semiconductor packaging substrate produced by method of manufacturing of embodiment have an effect of mitigating the warpage phenomenon of the substrate surface due to thermal expansion.

Although the preferred embodiment has been described in detail above, the scope of rights is not limited thereto, and various modifications and improvements of those skilled in the art using the basic concepts defined in the following claims also fall within the scope of rights.

## Claims

1. A semiconductor packaging substrate comprising:
a substrate comprising a one surface, other surface facing the one surface, a recessed surface that the one surface recessed, and a side wall connecting the one surface and the recessed surface; and
plurality of first vias that penetrating the recessed surface and the other surface,
wherein the plurality of first vias comprise a thermal conductive material.

2. The semiconductor packaging substrate of claim 1,
wherein the substrate comprises a glass substrate.

3. The semiconductor packaging substrate of claim 1,
wherein the substrate comprises an insulator substrate.

4. The semiconductor packaging substrate of claim 1,
wherein the one surface and the other surface have surface roughness Ra of 10 Å or less, respectively.

5. The semiconductor packaging substrate of claim 1,
wherein the substrate further comprises plurality of second vias that penetrating the one surface and the other surface.

6. The semiconductor packaging substrate of claim 1,
wherein an area of the recessed surface is 10% or larger than the area of the one surface.

7. A semiconductor packages comprising:
a substrate comprising a one surface, other surface facing the one surface, a recessed surface that the one surface recessed, and a side wall connecting the one surface and the recessed surface;
plurality of first vias that penetrating the recessed surface and the other surface; and
an element unit disposed on the recessed surface,
wherein the plurality of first vias comprise a thermal conductive material.

8. The semiconductor packages of claim 7,
wherein the element unit comprises an active element.

9. The semiconductor packages of claim 7,
further comprising filling materials covering the element unit, and
wherein the filling materials have a lower coefficient of thermal expansion than the substrate.

10. The semiconductor packages of claim 7,
wherein an angle between the side wall and the recessed surface is an obtuse angle.

11. A method for manufacturing the semiconductor packaging substrate comprising:
a preparation operation of forming a defect at a predetermined location on a one surface of a substrate, other surface facing the one surface, or both,
a via forming operation of applying an etchant to the substrate to form a plurality of vias and recessed surface, and
a filling operation of filling the plurality of vias with a thermal conductive material.
